# EUROPEAN PATENT APPLICATION

(11) **EP 4 467 690 A1**
(43) Date of publication of application: **27.11.2024**
(21) Application number: 22922207.0
(22) Date of filing: 26.12.2022
(51) Int. Cl.: C30B 29/38, H01L 29/872, H01L 33/32

(54) **ALUMINUM NITRIDE SINGLE CRYSTAL SUBSTRATE, SEMICONDUCTOR WAFER USING ALUMINUM NITRIDE SINGLE CRYSTAL SUBSTRATE, AND PRODUCTION METHODS THEREFOR**

(30) Priority: 20.01.2022 JP 2022007010
(71) Applicant: Stanley Electric Co. Ltd., Tokyo 153-8636 (JP)
(72) Inventor: KINOSHITA, Toru, Tokyo 153-8636 (JP)
(74) Representative: Pritzlaff, Stefanie Lydia
(86) International application number: PCT/JP2022/047879
(87) International publication number: WO 2023/140057

(57) **Abstract**

Problem

It is an objective to provide a single crystal AlN substrate that allows to manufacture a highly-reliable semiconductor device with high yield, a semiconductor wafer using the single crystal AlN substrate, and manufacturing methods of the same.

Solution

The single crystal AlN substrate according to the present invention includes a first surface and a second surface as an opposite side surface of the first surface. The first surface has a flat surface as an Al-polar surface and an inclined surface formed from an outer edge of the flat surface to a side surface. The second surface is an N-polar surface. The inclined surface is formed up to a position having a distance from an end portion of the single crystal AlN substrate in a direction along the flat surface of 0.45 mm or more and 0.75 mm or less, and is formed up to a position having a distance from the flat surface in a direction perpendicular to the flat surface of 0.2 mm or more and 0.3 mm or less.

## Description

### TECHNICAL FIELD

The present invention relates to a single crystal AlN substrate applicable in producing a semiconductor device including a light emitting element, such as a light emitting diode (LED) and a semiconductor laser (Laser Diode (LD)), a semiconductor wafer using the single crystal AlN substrate, and manufacturing methods of the same.

### BACKGROUND ART

For a substrate for laminating an AlGaN-based semiconductor layer when a semiconductor device of, for example, a deep-ultraviolet light emitting element, using an AlGaN-based semiconductor is manufactured, an AlN substrate is suitable from the aspect of, for example, easy lattice match.

For example, Patent Document 1 discloses a group III nitride laminated body having an n-type Al_{X}Ga_{1-X}N (0.5 ≤ X < 1) layer that is lattice-matched with an AlN single crystal substrate on the AlN single crystal substrate.

Patent Document 1: WO 2018/051772 pamphlet

### DISCLOSURE OF THE INVENTION

### PROBLEMS TO BE SOLVED BY THE INVENTION

As described above, in the case where an AlGaN-based semiconductor layer is grown on an AlN substrate, there has been a problem, when a natural oxide film is removed with an etchant as a pretreatment of crystal growth, that the etchant climbs up a side surface resulting in wrapping around up to a back surface even though an attempt of causing only a surface of the AlN substrate to be in contact with the etchant. If a back surface side of the AlN substrate is etched by the etchant thus wrapping around up to the back surface, an in-plane uniformity of a substrate temperature is degraded when the AlGaN-based semiconductor layer is laminated on a surface of the AlN substrate for forming a semiconductor device, which has posed a problem of having an effect on reliability and yield when the semiconductor device is formed.

The present invention has been made in consideration of the above-described problems, and it is an objective to provide a single crystal AlN substrate that allows to manufacture a highly-reliable semiconductor device with high yield, a semiconductor wafer using the single crystal AlN substrate, and manufacturing methods of the same.

### SOLUTIONS TO THE PROBLEMS

A single crystal AlN substrate according to the present invention includes a first surface and a second surface as an opposite side surface of the first surface. The first surface has a flat surface as an Al-polar surface and an inclined surface formed from an outer edge of the flat surface to a side surface. The second surface is an N-polar surface. The inclined surface is formed up to a position having a distance from an end portion of the single crystal AlN substrate in a direction along the flat surface of 0.45 mm or more and 0.75 mm or less, and is formed up to a position having a distance from the flat surface in a direction perpendicular to the flat surface of 0.2 mm or more and 0.3 mm or less.

A single crystal AlN substrate according to the present invention includes a first surface, a second surface as an opposite side surface of the first surface, a PVT-AlN layer, and a HVPE-AlN layer. The first surface has a flat surface as an Al-polar surface and an inclined surface formed from an outer edge of the flat surface to a side surface. The second surface is an N-polar surface. The PVT-AlN layer is formed by a PVT method. The PVT-AlN layer has a lower surface as the second surface. The HVPE-AlN layer is formed on an upper surface of the PVT-AlN layer by a HVPE method. The HVPE-AlN layer has an upper surface as the first surface. The HVPE-AlN layer has a layer thickness of 1/5 or less of a layer thickness of the PVT-AlN layer in an end surface of the single crystal AlN substrate.

A method for manufacturing a single crystal AlN substrate according to the present invention includes: a step (A) of forming a template substrate having an upper surface as an Al-polar surface by growing a HVPE-AlN layer by a HVPE method on a PVT-AlN layer formed by a PVT method; and a chamfering step (B) of forming an inclined surface that inclines from an outer edge of a flat surface that is the Al-polar surface to a side surface of the single crystal AlN substrate by performing a chamfering process on a peripheral edge portion of an upper surface of the HVPE-AlN layer. After the chamfering step (B), the HVPE-AlN layer has a layer thickness of 1/5 or less of a layer thickness of the PVT-AlN layer in the side surface of the single crystal AlN substrate.

A method for manufacturing a semiconductor wafer having a semiconductor layer formed on a single crystal AlN substrate according to the present invention includes: a step (A) of forming a template substrate having an upper surface as an Al-polar surface by growing a HVPE-AlN layer by a HVPE method on a PVT-AlN layer formed by a PVT method; a chamfering step (B) of forming an inclined surface that inclines from an outer edge of a flat surface that is the Al-polar surface to a side surface of the single crystal AlN substrate by performing a chamfering process on a peripheral edge portion of an upper surface of the HVPE-AlN layer; an immersing treatment step (C) of immersing the upper surface of the HVPE-AlN layer in an acid solution after the chamfering step (B); and a step (D) of forming a laminated film having an AlN layer and an AlₓGa₁₋ₓN (0.5 ≤ X ≤ 1) layer laminated in this order on the HVPE-AlN layer by a MOCVD method after the immersing treatment step (C). After the chamfering step (B), the HVPE-AlN layer has a layer thickness of 1/5 or less of a layer thickness of the PVT-AlN layer in the side surface of the single crystal AlN substrate.

### BRIEF DESCRIPTION OF THE DRAWINGS

FIG. 1 is a top view of a semiconductor wafer according to Embodiment 1.
FIG. 2 is a cross-sectional view illustrating a structure of a semiconductor wafer end portion according to Embodiment 1.
FIG. 3 is a cross-sectional view schematically illustrating a laminated structure of the semiconductor wafer of Embodiment 1.
FIG. 4 is a flowchart illustrating an outline of manufacturing steps of the semiconductor wafer using a single crystal AlN substrate of Embodiment 1.
FIG. 5 is a drawing illustrating a pretreatment step with an acid solution in the manufacturing steps of the semiconductor wafer of Embodiment 1.
FIG. 6 is a partially enlarged view of the drawing illustrating the pretreatment step of FIG. 5.
FIG. 7 is a cross-sectional view illustrating a structure of a semiconductor wafer end portion according to Embodiment 2.
FIG. 8 is a cross-sectional view illustrating a structure of a single crystal AlN substrate end portion according to a modification of Embodiment 2.
FIG. 9 is a cross-sectional view illustrating a structure of a semiconductor wafer end portion according to Embodiment 3.

### DESCRIPTION OF PREFERRED EMBODIMENTS

Preferrable examples of the present invention will be described below, and the examples may be modified and combined as necessary. In the following description and the attached drawings, substantially the same or equivalent portions are described with the same reference numerals.

### Embodiment 1

### [Configuration of Semiconductor Wafer Using Single Crystal AlN Substrate]

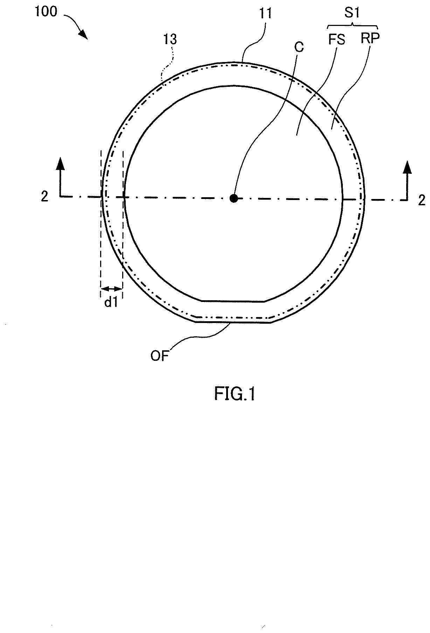

With reference to FIG. 1 to FIG. 3, a configuration of a semiconductor wafer 100 of the embodiment will be described. In the embodiment, the semiconductor wafer 100 is made by forming a semiconductor layer that serves as an ultraviolet light emitting diode (ultraviolet LED) as an ultraviolet semiconductor light emitting element on a single crystal AlN substrate 11.

FIG. 1 is a top view of the semiconductor wafer 100 of the embodiment. The semiconductor wafer 100 is configured of a semiconductor layer 13 laminated on the single crystal AlN substrate 11. In FIG. 1, in order to clarify a structure of the single crystal AlN substrate 11, the semiconductor layer 13 is indicated by a virtual line (two-dot chain line). For the convenience of illustration, the semiconductor layer 13 has an outer edge illustrated inside an outer edge of the substrate 11, but it will be understood that the semiconductor layer 13 is laminated over an entire upper surface of the substrate 11. The following describes the direction in which the semiconductor layer 13 exists when it is viewed from the substrate 11 is an upper side of the semiconductor wafer 100.

As illustrated in FIG. 1, the single crystal AlN substrate 11 is a disc-shaped substrate having an approximately circular planar shape with a point C as a center in top view. The single crystal AlN substrate 11 has one position on an outer periphery where an orientation flat OF indicating a crystal orientation of the single crystal AlN substrate 11 is formed.

The single crystal AlN substrate 11 has a first surface S1 as a surface on which the semiconductor layer 13 is formed. On the first surface S1, the single crystal AlN substrate 11 has a flat surface FS and an inclined surface RP formed to incline from an outer edge of the flat surface FS to an end portion of the single crystal AlN substrate 11, that is, an outer edge in top view.

As illustrated in FIG. 1, the inclined surface RP is formed to have a constant width d1. In other words, the inclined surface RP is formed in a region between the end portion of the single crystal AlN substrate 11 and a position separated by the distance d1 inwardly in a radial direction from the end portion. Further in other words, the inclined surface RP extends by the distance d1 inwardly from the end portion of the single crystal AlN substrate 11 in top view.

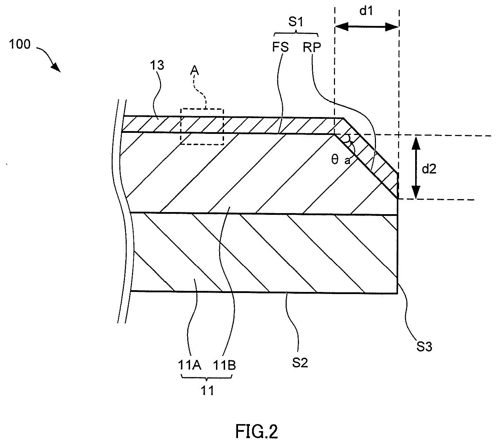

FIG. 2 is a partially enlarged cross-sectional view illustrating the shape near the end portion of the semiconductor wafer 100 of the cross-sectional surface of the semiconductor wafer 100 taken along the line 2-2 passing through the center C illustrated in FIG. 1.

As illustrated in FIG. 2, the single crystal AlN substrate 11 has a two-layer structure formed of a PVT-AlN layer 11A as an AlN-seed substrate produced by a physical vapor transport (PVT) method and a HVPE-AlN layer 11B as an AlN thick film grown by a hydride vapor phase epitaxy (HVPE) method on the PVT-AlN layer 11A.

As illustrated in FIG. 2, the single crystal AlN substrate 11 has a second surface S2 as an opposite side surface of the first surface, that is, a lower surface and a side surface S3, besides the first surface S1 as an upper surface.

As described above, the first surface S1 has the flat surface FS and the inclined surface RP.

The flat surface FS is a surface planarized by being polished by a known polishing method, such as chemical mechanical polishing (CMP). The flat surface FS is a C-plane and is an Al-polar surface. Accordingly, the flat surface FS is resistant against an etchant, such as a mixed solution of, for example, phosphoric acid and sulfuric acid, and a hydrofluoric acid, which etches the natural oxide film on the surface. The flat surface FS may be a crystal surface that slightly inclines from the C-plane, which is, it may be a crystal surface that has what is called an OFF angle. While the OFF angle is not specifically limited, setting it within a range of 0.1° to 0.5° ensures easily achieving a satisfactory smoothness when an AlGaN layer is laminated on the S1 surface. While the direction in which the flat surface FS slightly inclines is also determined appropriately, an M-axis direction in which a rectilinear step-terrace structure is achievable is preferred.

The inclined surface RP is formed to incline downward as approaching the end portion of the single crystal AlN substrate 11, that is, the side surface S3 from the outer edge of the flat surface FS, in other words, in a direction toward the second surface S2. That is, the inclined surface RP is an inclined surface that downwardly inclines toward an outside of the substrate 11.

The inclined surface RP can also be described as a chamfered portion that has chamfered a corner portion between the surface and the end surface of the single crystal AlN substrate 11.

Furthermore, the inclined surface RP can also be described as a tapered portion having a tapered shape formed between the flat surface FS and the side surface S3 of the single crystal AlN substrate 11.

As described above, the inclined surface RP extends by the distance d1 in the direction along the flat surface FS from the outer edge or a terminating end of the flat surface FS. That is, the inclined surface RP has a width of d1. The width d1 is a distance measured from the outer edge or the terminating end of the flat surface FS.

The inclined surface RP extends by a distance d2 in a direction perpendicular to the flat surface FS from the flat surface FS in side view. That is, the inclined surface RP has a depth or height of d2. The height d2 is a distance measured from an upper end of the surface perpendicular to the flat surface FS in a side portion of the single crystal AlN substrate 11 in side view, that is, an upper end of the side surface S3.

Note that the inclined surface RP may include a curved surface, and may have a rounded (R-shaped) cross-sectional surface. The width d1 of the inclined surface RP when it has the rounded cross-sectional surface shape is measured from the outer edge or the terminating end of the flat surface FS similarly to the case when it is not rounded. The height d2 of the inclined surface RP when it has the rounded cross-sectional surface shape is also measured from the upper end of the surface perpendicular to the flat surface FS, that is, the upper end of the side surface S3.

In this embodiment, the inclined surface RP is formed up to a position having the distance d1 from the end portion of the single crystal AlN substrate 11 of 0.45 mm or more and 0.75 mm or less (0.45 ≤ d1 ≤ 0.75). In other words, the width d1 in top view of the inclined surface RP is 0.45 mm or more and 0.75 mm or less.

The inclined surface RP is formed up to a position having the distance d2 from the flat surface FS in the direction perpendicular to the flat surface FS of 0.2 mm or more and 0.3 mm or less. In other words, the height d2 of the inclined surface RP is 0.2 mm or more and 0.3 mm or less (0.2 ≤ d2 ≤ 0.3).

The inclined surface RP having the dimensions d1, d2 described above inclines at an angle of 23° or more and 29° or less with respect to the flat surface FS. In other words, the angle between the inclined surface RP and the flat surface FS is 23° or more and 29° or less (in FIG. 2, 23° ≤ θa ≤ 29°).

The single crystal AlN substrate 11 in the embodiment is generated by, firstly, growing the disc-shaped single crystal AlN substrate using a seed substrate as a seed, and is formed by forming the inclined surface RP by grinding an outer edge of the first surface S1, that is, an element growth surface of the single crystal AlN substrate 11 of the main surface of the generated disc-shaped substrate. The disc-shaped substrate generated using the seed substrate is prone to generate slip dislocation due to a residual stress in a peripheral edge portion of the growth surface when it is subjected to temperature changes during the growth of the semiconductor layer. The above-described inclined surface RP is a portion generated by removing a portion prone to generate this slip dislocation.

In other words, the single crystal AlN substrate 11 having the inclined surface RP in this embodiment is a substrate from which the portion prone to generate the above-described slip dislocation is removed.

The second surface S2 may be a flat surface planarized by being polished by a known polishing method, such as chemical mechanical polishing, or may be a mechanically polished surface, which is, what is called, a lapped surface. The second surface S2 is a -C-plane, and is an N-polar surface. Accordingly, the second surface S2 has a property of being not resistant against an etchant, such as a mixed solution of, for example, phosphoric acid and sulfuric acid, and a hydrofluoric acid, that etches the natural oxide film on the surface, and a property of being etched by the etchant. Therefore, from a perspective of delaying the progress of etching, the planarized surface is preferrable.

The side surface S3 is a side end surface of the single crystal AlN substrate 11, and is a surface perpendicular to the substrate surface, a surface perpendicular to the flat surface FS. The side surface S3 may be a rough surface compared with the first surface S1 and the second surface S2.

The semiconductor layer 13 is formed of a plurality of AlGaN-based semiconductor layers including an active layer laminated by epitaxial growth on the first surface S1 of the single crystal AlN substrate 11.

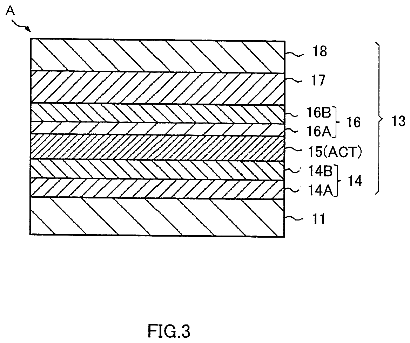

Here, with reference to FIG. 3, a layer configuration of the semiconductor layer 13 will be described. FIG. 3 is an enlarged view of a portion A surrounded by the dashed line in FIG. 2.

As illustrated in FIG. 3, the semiconductor layer 13 is formed of an n-type AlGaN layer 14 (hereinafter also referred to as the n-type AlₓGa₁₋ₓN (0 ≤ x ≤ 1) layer 14), an active layer 15, an AlGaN layer 16, a p-type AlGaN layer 17, and a p-type GaN layer 18 sequentially laminated on the single crystal AlN substrate 11 by epitaxial growth.

The n-type AlGaN layer 14 is an n-type conductive layer doped with Si (silicon). The n-type AlGaN layer 14 has an Al composition that can be determined appropriately such that sufficient permeability to a desired emission wavelength of ultraviolet light is achieved. For example, in the ultraviolet semiconductor light emitting element using the semiconductor wafer 100, the ultraviolet light emitted from the light emitting layer passes through the n-type AlGaN layer 14 and the single crystal AlN substrate 11 and is emitted to the outside. The larger the Al composition of the n-type AlGaN layer 14 becomes, the larger a band gap of the n-type AlGaN layer becomes, and accordingly, the ultraviolet light with a shorter wavelength can be transmitted.

The n-type AlₓGa₁₋ₓN (0 ≤ x ≤ 1) layer 14 may be formed of a plurality of layers with different Al compositions. For example, the n-type AlₓGa₁₋ₓN (0 ≤ x ≤ 1) layer 14 may include a laminated film in which an AlN layer and an AlₓGa₁₋ₓN(0.5 ≤ x ≤ 1) layer are laminated in this order.

An AlN buffer layer may be provided between the single crystal AlN substrate 11 and the n-type AlGaN layer 14.

Furthermore, the n-type AlₓGa₁₋ₓN (0 ≤ x ≤ 1) layer 14 may be a composition gradient layer in which the Al composition is graded in the lamination direction, that is, a direction away from the single crystal AlN substrate 11. For example, the n-type AlGaN layer 14 is formed of a first n-type AlxiGai-xiN layer 14A and a second n-type Al_{X2}Ga_{1-X2}N layer 14B as illustrated in FIG. 3. The first n-type Al_{X1}Ga_{1-X1}N layer 14A may be a composition gradient layer in which an Al composition X1 reduces from 1.0 to 0.75 in the lamination direction, and the second n-type Al_{X2}Ga_{1-X2}N layer 14B may be a composition gradient layer in which an Al composition X2 reduces from 0.75 to 0.70.

The n-type AlGaN layer 14 has a film thickness that is not specifically limited, but is determined appropriately. For example, the film thickness of the n-type AlGaN layer 14 is preferably 0.5 µm or more and 2 µm or less. This is because, if the film thickness of the n-type AlGaN layer is too thick when the single crystal AlN substrate 11 is used, the n-type AlGaN layer has a lattice relaxation and dislocation is likely to occur, even though a thick film thickness of the n-type AlGaN layer is preferable from the aspect of reducing a resistance value of the n-type AlGaN layer.

For example, when the n-type AlGaN layer 14 is formed as a laminated structure formed of the first n-type AlxiGai-xiN layer 14A and the second n-type Al_{X2}Ga_{1-X2}N layer 14B described above, the first n-type Al_{X1}Ga_{1-X1}N layer 14A may have a layer thickness of 200 nm and the second n-type Al_{X2}Ga_{1-X2}N layer 14B may have a layer thickness of 1000 nm. These film thicknesses of the first n-type AlxiGai-xiN layer 14A and the second n-type Al_{X2}Ga_{1-X2}N layer 14B are not limited to the numbers exemplarily indicated, and are determined appropriately such that the total film thickness is 2.0 µm or less.

A Si concentration doped in the n-type AlGaN layer 14 is only necessary to be determined appropriately such that a desired n-type conductive property is achieved, but from the aspect of reducing a resistance value of the n-type AlGaN layer 14, 1×10¹⁸ to 1×10²⁰cm⁻³ is preferred, and furthermore, 5×10¹⁸ to 5×10¹⁹cm⁻³ is preferred. The Si doping concentration may be constant in a film thickness direction in the n-type AlGaN layer 14, or modulation doping in which the Si concentration is changed in the film thickness direction may be employed.

The active layer (ACT) 15 has a quantum well structure configured of a barrier layer formed of an Al_{A1}Ga_{1-A1}N layer and a well layer formed of an Al_{A2}Ga_{1-A2}N layer. The active layer 15 has a light emission peak wavelength within a range of 210 nm to 300 nm. The optical wavelength emitted from the active layer 15 is determined by the Al composition and the film thickness of the well layer, and therefore, the Al composition and the film thickness can be determined appropriately such that a desired emission wavelength can be obtained in the above-described wavelength range.

For example, the film thickness of the well layer can be set in a range of 2 nm to 10 nm, and the Al composition can be determined such that a desired emission wavelength is achieved. The Al composition and the film thickness of the barrier layer are also not specifically limited, and, for example, the Al composition may be set within a range of A2 < A1 ≤ 1.0, and the film thickness may be set within a range of 2 nm to 15 nm.

The well layer and the barrier layer may be an n-type layer doped with Si. The structure may have both the well layer and the barrier layer being a Si doping layer, or only the well layer or only the barrier layer being doped with Si. The doped Si concentration is not specifically limited, but a range of 1×10¹⁷ to 5×10¹⁸cm⁻³ is preferred.

The number of layers of the quantum well is also not specifically limited, a multi quantum well (MQW) structure in which a plurality of well layers are formed may be employed or a single quantum well (SQW) may be employed. The number of the well layers is preferred to be determined appropriately within a range of 1 to 5.

The Al_{Y1}Ga_{1-Y1}N layer 16 is a layer provided adjacently on the active layer 15. The Al_{Y1}Ga_{1-Y1}N layer 16 functions as an electron blocking layer (EBL) for suppressing the electrons injected to the active layer 15 overflowing to the p-type Al_{Y2}Ga_{1-Y2}N layer 17. Therefore, the Al_{Y1}Ga_{1-Y1}N layer 16 has a band gap larger than those of the active layer 15 and the p-type Al_{Y2}Ga_{1-Y2}N layer 17, which will be described later, and the Al_{Y1}Ga_{1-Y1}N layer 16 has an Al composition Y1 that is determined in a range of 0.8 < Y1 ≤ 1.0.

In association with the shortened wavelength of the emission wavelength, the Al composition in the AlGaN layer that epitaxially grows on the substrate 11 increases, when the emission wavelength is shorter than 270 nm, the Al composition Y1 is preferred to be 0.9 ≤ Y1 ≤ 1.0 in order to sufficiently develop a function as an electron blocking layer. Note that, in the embodiment, AlN (Y1 = 1) is used for the Al_{Y1}Ga_{1-Y1}N layer 16.

The Al_{Y1}Ga_{1-Y1}N layer 16 may be an undoped layer or may be doped with a p-type dopant as long as it can develop the function as the electron blocking layer. For the p-type dopant material in the Al_{Y1}Ga_{1-Y1}N layer 16, Mg (magnesium), Zn (zinc), Be (beryllium), C (carbon), or the like is useable. In particular, it is preferred to use Mg, which is generally used as a p-type dopant material of an AlGaN layer.

The p-type dopant material may be evenly doped in the lamination direction of the Al_{Y1}Ga_{1-Y1}N layer 16, or concentrations of the dopant material may be changed in the lamination direction. For example, a laminated structure formed of an undoped AlN layer 16A (Y1 = 1) and a p-type AlN layer 16B doped with Mg (magnesium) may be formed from a side in contact with the active layer.

While the p-type dopant concentration in the Al_{Y1}Ga_{1-Y1}N layer 16 is not specifically limited, 5×10¹⁸ to 1×10²⁰ cm⁻³ is preferred in order to obtain the function as the electron blocking layer, and 1×10¹⁹ to 8×10¹⁹cm⁻³ is particularly preferred from the perspective that injection efficiency of the carrier to the light emitting layer can be enhanced.

The Al_{Y1}Ga_{1-Y1}N layer 16 of the present invention does not include the n-type dopant or is allowed to include the n-type dopant by a concentration of less than the n-type dopant included in the p-type Al_{Y2}Ga_{1-Y2}N layer 17, which will be described later. Specifically, an n-type impurity concentration in the Al_{Y1}Ga_{1-Y1}N layer 16 is preferred to be 1×10¹⁸ cm⁻³ or less. From the findings by the inventors, dopant diffusion is known to occur between the p-type Al_{Y2}Ga_{1-Y2}N layer 17 and the adjacent Al_{Y1}Ga_{1-Y1}N layer 16 while the p-type Al_{Y2}Ga_{1-Y2}N layer 17 is growing. Therefore, when the n-type dopant concentration in the Al_{Y1}Ga_{1-Y1}N layer 16 is higher than that of the p-type Al_{Y2}Ga_{1-Y2}N layer 17, the n-type dopant diffuses from the inside of the Al_{Y1}Ga_{1-Y1}N layer 16 to the p-type Al_{Y2}Ga_{1-Y2}N layer 17 to cause a difficulty in precisely controlling the n-type dopant concentration in the p-type Al_{Y2}Ga_{1-Y2}N layer 17 in some cases. In order to prevent the concentration change of the n-type dopant in the p-type Al_{Y2}Ga_{1-Y2}N layer 17 due to this diffusion, at least the n-type dopant in the Al_{Y1}Ga_{1-Y1}N layer 16 needs to have a concentration less than a concentration of the n-type dopant included in the p-type Al_{Y2}Ga_{1-Y2}N layer 17.

While the film thickness of the Al_{Y1}Ga_{1-Y1}N layer 16 is allowed to be determined appropriately such that the function as the electron blocking layer and efficient injection of holes to the active layer from the p-type Al_{Y2}Ga_{1-Y2}N layer 17 are achieved, a range of 1 nm to 30 nm is preferred. When the film thickness is below 1 nm, the electrons tunnel, and therefore, the function as the electron blocking layer is deteriorated, whereas when the film thickness exceeds 30 nm, the holes are less likely to be injected to the active layer from the p-type Al_{Y2}Ga_{1-Y2}N layer 17. Taking these into consideration, the film thickness of the Al_{Y1}Ga_{1-Y1}N layer 16 is preferred to be 2 nm to 20 nm, and is further preferably 5 nm to 15 nm.

As described above, Mg doped in the Al_{Y1}Ga_{1-Y1}N layer 16 is allowed to have concentration difference in the lamination direction. For example, a structure in which the undoped AlN layer 16A is laminated with a layer thickness of 1 nm to 5 nm on the side in contact with the active layer 15, and the p-type AlN layer 16B doped with Mg is further laminated by 5 nm to 15 nm is also allowed. The doping concentration of Mg at this time is preferred to be 5×10¹⁸ to 1×10²⁰ cm⁻³, and is particularly preferred to be 1×10¹⁹ to 8×10¹⁹ cm⁻³ similarly to what is described above.

The p-type Al_{Y2}Ga_{1-Y2}N layer 17 of the present invention is formed on the Al_{Y1}Ga_{1-Y1}N layer 16, and functions as a p-type cladding layer. The p-type Al_{Y2}Ga_{1-Y2}N layer 17 is co-doped with p-type impurities that serve as an acceptor and n-type impurities that serve as a donor.

For the p-type impurities doped in the p-type Al_{Y2}Ga_{1-Y2}N layer 17, Mg (magnesium), Zn (zinc), Be (beryllium), C (carbon), or the like may be used. Among these, Mg, which is generally used as a p-type dopant material of an AlGaN semiconductor, is preferred to be used. For the n-type impurities, Si, Ge (germanium), Se (selenium), S (sulfur), O (oxygen), or the like is allowed to be used. Among these, Si, which is generally used as an n-type dopant, is preferred to be used.

An amount of the p-type impurities doped in the p-type Al_{Y2}Ga_{1-Y2}N layer 17 is preferred to be 1×10¹⁷ to 1.2×10²⁰ cm⁻³. As theoretically described in J. Appl. Phys. Vol. 95, No. 8, 15 April (2004), it is considered that an amount of nitrogen deficiency considered to be a cause of deterioration increases in association with the amount of the p-type impurities in the p-type Al_{Y2}Ga_{1-Y2}N layer 17. Therefore, when the amount of the p-type impurities exceeds 1.2×10²⁰ cm⁻³, the amount of nitrogen deficiency formed in the beginning increases too much to make it difficult to obtain a high output maintenance rate.

In the case where the p-type impurity concentration is decreased, it becomes difficult to obtain high light emission efficiency due to an output reduction by decreased hole concentration and increased mobility of a minority carrier (the electrons) when, in particular, the Al composition Y2 is constant, and by increased mobility of the minority carrier (the electrons) when the Al composition Y2 is graded. Therefore, the p-type impurity concentration is allowed to be determined appropriately within the above-described range by taking such trade-off into consideration, and in order to obtain higher output maintenance rate and high output, 1×10¹⁹ to 5×10¹⁹ cm⁻³ is preferred, and 1×10¹⁹ to 4×10¹⁹ cm⁻³ is further preferred.

The n-type impurities doped in the p-type Al_{Y2}Ga_{1-Y2}N layer 17 is preferred to be 1.1×10¹⁸ or more and 9.0×10¹⁸ cm⁻³ or less, and is further preferred to be 1.8×10¹⁸ or more and 8.0×10¹⁸ cm⁻³ or less. These amounts of the n-type impurities allow achieving a light emitting element with high light emission efficiency.

The p-type impurities and n-type impurities doped in the p-type Al_{Y2}Ga_{1-Y2}N layer 17 may have their concentrations constant in the layer or may have concentration difference in the lamination direction. For example, it is also allowed to make the side in contact with the Al_{Y1}Ga_{1-Y1}N layer 16 a co-doped layer, and the remaining p-type Al_{Y2}Ga_{1-Y2}N layer 17 a layer without n-type impurities doped.

The Al composition Y2 of the p-type Al_{Y2}Ga_{1-Y2}N layer 17 is 0.5 or more and 1.0 or less, and is equal to or less than the Al composition Y1 of the Al_{Y1}Ga_{1-Y1}N layer 16.

The Al composition Y2 of the p-type Al_{Y2}Ga_{1-Y2}N layer 17 is preferred to exceed an Al composition of the barrier layer of the active layer and be equal to or less than the Al composition Y1 of the Al_{Y1}Ga_{1-Y1}N layer 16, when the structure has a constant value of Y2 in the lamination direction. Keeping the Al composition Y2 of the p-type Al_{Y2}Ga_{1-Y2}N layer 17 within the above-described range ensures achieving a high inhibitive effect of carrier overflow even when an amount of inj ection current of the ultraviolet light emitting element is large. In order to obtain a higher effect, the difference between the Al composition of the barrier layer of the active layer and the Al composition Y2 of the p-type Al_{Y2}Ga_{1-Y2}N layer 17 is preferred to be 0.5 or more. The Al composition Y2 of the p-type Al_{Y2}Ga_{1-Y2}N layer 17 is preferably larger than the Al composition of the n-type AlGaN layer 14, thereby enhancing the inhibitive effect of carrier overflow to the p-type layer, thus allowing enhanced light emission efficiency of the ultraviolet light emitting element. Based on the above, the Al composition Y2 of the p-type Al_{Y2}Ga_{1-Y2}N layer 17 is preferred to be 0.6 or more and 0.9 or less when the structure has Y2 in a constant value in the lamination direction.

The p-type Al_{Y2}Ga_{1-Y2}N layer 17 may be a composition gradient layer that has the Al composition Y2 changing in the lamination direction. In particular, it is preferred that the structure has the Al composition Y2 decreasing in the lamination direction from the side in contact with the Al_{Y1}Ga_{1-Y1}N layer 16. This ensures achieving a polarization doping effect in the p-type Al_{Y2}Ga_{1-Y2}N layer 17, and therefore, a higher hole concentration is likely to be achieved, and as the result, hole injection efficiency to the active layer is enhanced. For example, when the emission wavelength is 270 nm or less, the Al composition in the side in contact with the Al_{Y1}Ga_{1-Y1}N layer 16 is preferred to be 0.95 to 1.0, and the Al composition in a superficial layer of the p-type Al_{Y2}Ga_{1-Y2}N layer 17 on the opposite side is preferred to be 0.60 to 0.85. Employing such a structure allows enhancing the above-described polarization doping effect and maintaining a transparency in the emission wavelength, and therefore, high light emission efficiency is more likely to be achieved.

The film thickness of the p-type Al_{Y2}Ga_{1-Y2}N layer 17 is not specifically limited, and may be determined appropriately within a range of 10 nm to 150 nm. When the film thickness of the p-type Al_{Y2}Ga_{1-Y2}N layer 17 is less than 10 nm, the above-described carrier overflow inhibitive effect is less likely to be achieved, and on the other hand, when the film thickness is thicker and exceeding 150 nm, the resistance value of the p-type Al_{Y2}Ga_{1-Y2}N layer 17 increases, resulting in an increased operating voltage of the ultraviolet light emitting element. From such an aspect, the film thickness of the p-type Al_{Y2}Ga_{1-Y2}N layer 17 is preferred to be 40 nm to 120 nm, and particularly preferred to be 50 nm to 100 nm.

The p-type GaN layer 18 doped with a p-type dopant may be formed on the p-type Al_{Y2}Ga_{1-Y2}N layer 17 for the purpose of decreasing a contact resistance with the electrode. While the above-described known p-type dopant material may be used for the p-type dopant material, it is preferred to use Mg for the similar reason. The doping concentration of Mg in the p-type GaN layer 18 is not specifically limited, but in order to decrease the resistance value in the p-type GaN layer and decrease the contact resistance with the electrode, it is preferred to be 1×10¹⁸ to 2×10²⁰ cm⁻³. The film thickness of the p-type GaN layer 18 is not specifically limited, and may be determined appropriately in a range of 5 nm to 500 nm.

Note that, excluding the p-type GaN layer 18, all the layers of the AlGaN layers 14, 15, 16, and 17 have crystals grown in a state of lattice matched with the single crystal AlN substrate 11, and therefore, have dislocation densities as low as that of the single crystal AlN substrate 11.

In the present invention, the single crystal AlN substrate 11 is not specifically limited, but is preferred to have low dislocation density in consideration of a quality of the semiconductor layer 13 grown on the single crystal AlN substrate 11. Specifically, the dislocation density of the single crystal AlN substrate 11 is preferred to be 10⁶ cm⁻² or less, and is further preferred to be 10⁴ cm⁻² or less. The single crystal AlN substrate 11 having low dislocation density ensures lowering the dislocation density within the AlGaN layers formed on the single crystal AlN substrate 11. Thus, for example, the properties of the ultraviolet light emitting element using the single crystal AlN substrate 11 is improvable.

Note that a large surface roughness of the above-described flat surface FS causes abnormal growth and the like in the AlGaN layers growing on the flat surface FS. Therefore, the surface roughness (RMS) of the flat surface FS of the single crystal AlN substrate 11 is preferably 5.0 nm or less, further preferably 1.0 nm or less, and further preferably 0.5 nm or less.

When the absorption coefficient of the substrate for the ultraviolet light emitted from the active layer is large in the light emitting element using the single crystal AlN substrate 11, the total quantity of the ultraviolet light allowed to be taken out is reduced, thereby posing a concern of reduced light emission efficiency. Therefore, the absorption coefficient of the single crystal AlN substrate 11 is preferably 20 cm⁻¹ or less, and further preferably 10 cm⁻¹ or less. The absorption coefficient of the single crystal AlN substrate 11 being 10 cm⁻¹ or less ensures securing a linear transmittance of 90% or more even when, for example, the single crystal AlN substrate 11 has a plate thickness of 100 µm.

For example, keeping the content of the impurities, such as carbon, in the single crystal AlN substrate 11 low decreases the absorption coefficient, and thus, optical transparency can be ensured. For example, in order to sufficiently decrease the absorption coefficient, the carbon concentration in the single crystal AlN substrate 11 is preferred to be 5×10¹⁷ cm⁻³ or less.

### [Manufacturing Method]

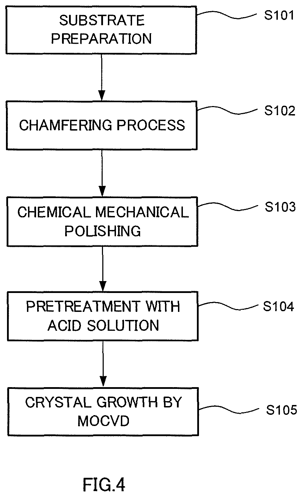

With reference to FIG. 4 to FIG. 6, manufacturing process of the single crystal AlN substrate 11 and of the semiconductor wafer 100 using the same will be described.

FIG. 4 is a flowchart illustrating an outline of manufacturing process of the semiconductor wafer 100.

First, a template substrate for producing the single crystal AlN substrate 11 is prepared (Step S101). At Step S101, the PVT-AlN layer 11A is produced by a PVT method, and the HVPE-AlN layer 11B is grown on the PVT-AlN layer 11A by a HVPE method using the PVT-AlN layer 11A as a seed substrate, and thus, the single crystal AlN substrate having a two-layer structure serves as a template substrate.

The upper surface of the PVT-AlN layer 11A is an Al-polar surface that has the HVPE-AlN layer 11B laminated on the upper surface. Accordingly, the upper surface of the HVPE-AlN layer 11B as an upper surface of the template substrate is the Al-polar surface, and a lower surface of the PVT-AlN layer 11A as a lower surface of the template substrate is an N-polar surface.

For example, there is a case where desired optical transparency fails to be achieved when a single crystal AlN is grown by the PVT method because coloring caused by the impurities is likely to occur. On the other hand, when a single crystal AlN is grown by the HVPE method, the impurities are difficult to be mixed in, thus easily achieving optical transparency. Therefore, this embodiment employs a substrate for producing the single crystal AlN substrate 11 by forming a single crystal AlN by the HVPE method on a single crystal AlN formed by the PVT method. For example, after forming a light emitting element, a portion formed by the PVT method of the single crystal AlN substrate 11 may be removed. Thus, the optical transparency of the substrate after forming the light emitting element can be ensured.

At Step S101, the upper surface of the HVPE-AlN layer 11B is the Al-polar surface, and the lower surface of the PVT-AlN layer 11A is the N-polar surface.

Next, a chamfering process is performed on an outer periphery portion on the surface side of the single crystal AlN substrate prepared at Step S101, and thus, the single crystal AlN substrate 11 is produced (Step S102). At Step S102, the chamfering process is performed to form the inclined surface RP illustrated in FIG. 2.

Specifically, as described above, the inclined surface RP is formed up to the position having the distance from the end portion of the single crystal AlN substrate 11 in the direction along the flat surface FS of 0.45 mm or more and 0.75 mm or less, and is formed up to the position having the distance from the flat surface FS in the direction perpendicular to the flat surface FS of 0.2 mm or more and 0.3 mm or less.

In other words, the inclined surface RP is formed to have the distance d1 from the end portion of the single crystal AlN substrate 11 illustrated in FIG. 2 of 0.45 mm or more and 0.75 mm or less (0.45 ≤ d1 ≤ 0.75), and the distance d2 from the flat surface FS in the direction perpendicular to the flat surface FS of 0.2 mm or more and 0.3 mm or less (0.2 ≤ d2 ≤ 0.3).

At Step S102, the chamfering process is, for example, performed by grinding process by a known chamfering machine. For example, a portion having an orientation flat or a notch is also similarly ground to provide the inclined surface RP.

Afterwards, chemical mechanical polishing is performed to form the flat surface FS and the second surface S2 (Step S103). For example, the inclined surface RP may become a rounded surface by chemical mechanical polishing at Step S103 after the chamfering process.

The single crystal AlN substrate 11 is produced by Step S101 to Step S103.

Afterwards, in order to remove the natural oxide film formed on the surface of the single crystal AlN substrate 11 as a pretreatment of crystal growth for forming an ultraviolet light emitting element on the single crystal AlN substrate 11, the flat surface FS of the single crystal AlN substrate 11 is immersed in an acid solution (Step S104). At Step S104, for example, a mixed solution of phosphoric acid:sulfuric acid = 1:3 is used as the acid solution, and the process is performed for 10 minutes at a process temperature of 70°C.

At Step S104, the process is kept for a predetermined processing time in a state where only the flat surface FS of the single crystal AlN substrate 11 is brought into contact with the acid solution and a back surface of the single crystal AlN substrate 11, that is, the second surface S2 in FIG. 2 is exposed out of the acid solution.

The flat surface FS is the Al-polar surface as described above, and therefore, only the natural oxide film is etched with the acid solution and the surface of AlN is less likely to be etched. In contrast to this, the second surface S2 is the N-polar surface, and therefore, it is likely to be etched with the acid solution. Therefore, at Step S104, in order to avoid the second surface S2 from being etched with the acid solution as an etchant that removes the natural oxide film, only the flat surface FS is processed in a state where the second surface S2 of the single crystal AlN substrate 11 is exposed from the acid solution.

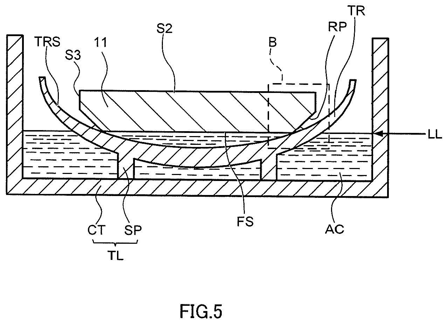

FIG. 5 is a cross-sectional view illustrating a state where only the flat surface FS of the single crystal AlN substrate 11 is immersed in an acid solution AC using a tool TL made of Teflon (registered trademark) at Step S104 of the above-described manufacturing steps. In FIG. 5, LL indicates the height of a liquid surface of the acid solution AC.

As illustrated in FIG. 5, the tool TL has a container portion CT that houses a liquid and a supporting portion SP that is fixed to the container portion to support a wafer. The supporting portion SP includes a receiving portion TR having a substrate receiving surface TRS with a bottom surface shape that is convex downward. The receiving portion TR supports the single crystal AlN substrate 11 via the substrate receiving surface TRS in contact with a boundary portion between the flat surface FS and the inclined surface RP of the single crystal AlN substrate 11. The receiving portion is, for example, made of a mesh-like member, and the acid solution AC in the container portion CT accesses the flat surface FS of the single crystal AlN substrate 11 passing through the mesh-like member.

The acid solution AC is injected into the tool TL such that the liquid surface LL of the acid solution AC has a height that exactly comes in contact with flat surface FS.

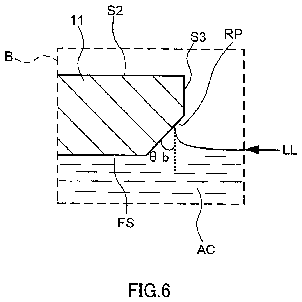

FIG. 6 is a drawing that enlarges and illustrates the part B surrounded by the dashed line in FIG. 5. In FIG. 6, the tool TL is omitted.

As described above, injecting the acid solution AC such that the liquid surface LL of the acid solution AC has the height to come in contact with the flat surface FS causes the acid solution AC to spread and wet over the entire flat surface FS. At this time, the acid solution AC attempts to climb up toward the side surface S3 due to the effect of surface tension as illustrated in FIG. 6.

If compared with an angle θ (not illustrated, a contact angle θ) between a tangent line drawn from the point where the acid solution AC comes in contact with the side surface S3 to the liquid surface and the side surface S3 when the acid solution AC climbs up to the side surface S3, an angle θb (a contact angle θb between the inclined surface RP and the acid solution AC) between a tangent line drawn from the point where the acid solution AC comes in contact with the inclined surface RP to the liquid surface and the inclined surface RP is larger.

Here, cos θ > cos θb is obtained by considering that the force of the liquid attempting to climb up the solid surface is proportionate to cos θ, and therefore, the force of the acid solution AC attempting to climb up the inclined surface RP is smaller than the force of attempting to climb up a vertical surface, like the side surface S3. That is, it can be said that the acid solution AC has more difficulty in climbing up the inclined surface RP than in climbing up the side surface S3. In consideration of this respect, it can be said that forming the inclined surface RP causes the acid solution AC to less likely to wrap around up to the second surface S2 via the side surface of the substrate 11.

In this embodiment, the distance d1 (width) from the end portion of the single crystal AlN substrate 11 and the distance d2 (height) in the perpendicular direction from the flat surface FS are set sufficiently larger than the cases of simple chamfering process that has been conventionally performed in relation to the dimensions of the inclined surface RP, and thus, climbing up of the acid solution AC stops within the range of the inclined surface RP and does not reach the side surface S3. Thus, the inclined surface RP plays a role of preventing the acid solution AC that has been spread and wet the flat surface FS from reaching the side surface S3.

For example, if the inclined surface RP does not have enough width or height, the acid solution AC reaches the side surface S3, and furthermore, climbs up the side surface S3 to reach the second surface S2. In such a case, only the portion of the second surface S2 where the acid solution AC has reached is etched to cause non-uniform thickness or surface roughness of the single crystal AlN substrate 11. Specifically, the region along the outer periphery of the second surface S2 is partially etched to create a portion with large unevenness or surface roughness.

The second surface S2 is a surface in contact with a susceptor that heats the substrate 11 when the semiconductor layer 13 is grown on the substrate 11. If the portion with large unevenness or surface roughness as described above is created on this surface, a crystal growth temperature during forming the AlGaN layer on the single crystal AlN substrate 11 becomes non-uniform, and when a semiconductor device is formed from such a semiconductor wafer, the formed semiconductor device has a lowered reliability and the yield of the semiconductor device is lowered.

In this embodiment, disposing the inclined surface RP prevents the acid solution AC from wrapping around up to the back surface. Specifically, as illustrated in FIG. 2, there is disposed the inclined surface RP having the distance d1 from the end portion of the single crystal AlN substrate 11 of 0.45 mm or more and 0.75 mm or less (0.45 ≤ d1 ≤ 0.75) and the distance d2 from the flat surface FS in the direction perpendicular to the flat surface FS of 0.2 mm or more and 0.3 mm or less (0.2 ≤ d2 ≤ 0.3).

Such dimensions of the inclined surface RP are dimensions that allow preventing the acid solution AC from wrapping around up to the second surface S2 of the single crystal AlN substrate 11. At the same time, the dimensions minimize a portion that cannot be employed as the device caused by the reduced area of the flat surface FS of the single crystal AlN substrate 11 due to disposing the inclined surface RP when the semiconductor device is formed. Therefore, without lowering the yield, the semiconductor device with high reliability can be achieved.

Returning to the description of FIG. 4, after Step S104, the single crystal AlN substrate 11 after pure water rinsing and drying is introduced to a MOCVD device, and the crystal growth of the semiconductor layer 13 is performed (Step S105). At Step S105, the n-type AlGaN layer 14, the active layer 15, the AlGaN layer 16, the p-type AlGaN layer 17, and the p-type GaN layer 18 illustrated in FIG. 3 are grown to obtain the semiconductor wafer 100.

In the crystal growth of the semiconductor layer 13 at Step S105, a group III (Al, Ga) source gas, a group V (N) source gas are supplied onto the single crystal AlN substrate 11 together with a carrier gas, such as hydrogen and/or nitrogen. The group III (Al, Ga) source gas, the group V (N) source gas used here are not specifically limited, and a known source gas is usable.

For example, for the group III source gas, a gas, such as trimethylaluminum, triethylaluminum, trimethylgallium, and triethylgallium, is usable. For the group V source gas, ammonia is usually used.

Also for a dopant source gas of Mg and/or Si, a known material is usable without limitation, and, for example, bis(cyclopentadienyl)magnesium, monosilane, tetraethylsilane, or the like is usable.

While a supply amount ratio (V/III ratio) of the group III source gas to the group V source gas is simply determined appropriately so as to be able to achieve desired properties, it is preferred to set within a range of 500 to 10000.

While growth temperatures of the respective layers constituting the semiconductor layer 13 are not specifically limited, and are simply determined appropriately so as to be able to achieve desired properties of the respective layers and properties of the ultraviolet LED, it is preferred that the growth takes place at 1000°C to 1200°C, and more preferably at 1000°C to 1150°C.

Note that the semiconductor layer 13 can be manufactured by a known crystal growth method, such as a molecular beam epitaxy (MBE) method, other than the MOCVD method. Among these, the MOCVD method, which is highly productive and industrially widely employed, is preferable.

With the above-mentioned manufacturing steps, the semiconductor layer 13 was formed on the single crystal AlN substrate 11 and the semiconductor wafer 100 was obtained.

The effect of preventing the acid solution AC from wrapping around during the manufacture of the wafer 100 and the effect of preventing slip defect from occurring in the semiconductor layer 13 of the wafer 100 were examined.

Specifically, a first embodiment sample and a second embodiment sample having the inclined surface RP of the semiconductor wafer 100 in the following dimensions were produced.
the first embodiment sample: d1 = 0.47 mm, d2 = 0.20 mm
the second embodiment sample: d1 = 0.69 mm, d2 = 0.31 mm

For comparative examples, there were produced a first comparative example sample and a second comparative example sample similar to the semiconductor wafer 100 except that they have a conventional chamfering structure including a chamfered portion that is located at a position corresponding to the position of the inclined surface RP and has a height and a width smaller than those of the inclined surface RP.

The dimensions of the conventional chamfered portion is represented by the distance d1 measured from the outer edge or the terminating end of the flat surface FS in the direction along the flat surface FS and the distance d2 measured from the upper end of the surface perpendicular to the flat surface FS in the side portion of the single crystal AlN substrate in side view.

The first comparative example sample and the second comparative example sample have the following dimensions.
the first comparative example sample: d1 = 0.34 mm, d2 = 0.17 mm
the second comparative example sample: d1 = 0.28 mm, d2 = 0.17 mm

Accordingly, the first comparative example sample and the second comparative example sample do not satisfy the requirements as the inclined surface RP of 0.45 ≤ d1 ≤ 0.75 and 0.2 ≤ d2 ≤ 0.3, but are d1 < 0.45, d2 < 0.2. Accordingly, the comparative examples have a chamfered portion with the dimensions smaller than those of the inclined surface RP of the examples.

In the first embodiment sample and the second embodiment sample, no traces caused by the acid solution AC wrapping around up to the second surface S2, that is, the back surface were observed.

On the other hand, there were cases where the traces of the liquid that has moved from the outer periphery toward the inner side were observed on the back surfaces of the semiconductor wafers of the first comparative example sample and the second comparative example sample. In the case of the first comparative example sample and the second comparative example sample, it is considered that prevention of the acid solution AC from reaching the side surface was failed during the pretreatment with the acid solution AC before the growth of the semiconductor layer, and the acid solution AC reached the side surface of the substrate having the conventional chamfering structure, which resulted in further reaching the back surface.

In the first comparative example sample and the second comparative example sample having the conventional chamfered portion without having the inclined surface RP, a linear defect (slip defect) in a straight line starting from the proximity of the outer periphery portion of the semiconductor layer 13 was likely to occur.

The single crystal AlN substrates of the comparative examples have a strain that has been generated during the crystal growth or the like when the single crystal AlN substrate was manufactured. Accordingly, it is considered that causing the semiconductor layer to grow thereon moved a part of the crystal mainly in the outer periphery portion of the substrate when the stress was released by the effect of temperature rising or the like during the growth to generate a level difference on the substrate surface, and thus, the linear defect occurred.

Furthermore, the two-layer structure having the single crystal AlN layer formed by the HVPE method on the single crystal AlN layer formed by the PVT method as in this embodiment tends to often have a strain remaining in the HVPE-AlN layer, which is likely to cause a slip along the M surface.

When the linear defect is included in the element, the reliability of the element is lowered, and therefore, the element including the linear defect is handled as a failure. Therefore, the occurrence of the linear defect leads to the lowered yield.

There was observed no linear defect starting from the outer periphery portion in the semiconductor wafer 100 having the inclined surface RP of this embodiment. Specifically, no linear defect occurred in both the first embodiment sample and the second embodiment sample described above.

It is presumed that disposing the inclined surface RP removes a portion with a strain or easily releases the strain even if it remains, and thus, the linear defect is hard to occur in this embodiment.

According to the above, the dimensions of the inclined surface RP of this embodiment is considered to be dimensions that allow sufficiently releasing a strain that causes the occurrence of the above-described linear defect.

As described in detail above, the single crystal AlN substrate 11 in the semiconductor wafer 100 of this embodiment has the first surface S1, the second surface S2 as the opposite side surface of the first surface, and the side surface S3. The first surface S1 has the flat surface FS and the inclined surface RP formed to incline toward the second surface S2 from the outer edge of the flat surface FS to the side surface S3. The flat surface FS is the Al-polar surface, and the second surface S2 is the N-polar surface.

The inclined surface RP is formed up to the position at 0.45 mm or more and 0.75 mm or less from the end portion of the single crystal AlN substrate 11 in the direction along the flat surface FS. The inclined surface RP is formed up to the position at 0.2 mm or more and 0.3 mm or less from the flat surface FS in the direction perpendicular to the flat surface FS.

The semiconductor wafer 100 of this embodiment has the semiconductor layer 13 formed on the first surface S1 of the single crystal AlN substrate 11.

Such a configuration allows preventing the acid solution from spreading to the side surface S3 and the second surface S2 when only the flat surface FS is immersed in the acid solution as the pretreatment when the semiconductor layer 13 is formed according to this embodiment. The lowered reliability of the device caused by temperature variation or the like during the growth of the semiconductor layer 13 is preventable.

With this embodiment, the occurrence of the linear defect in the semiconductor wafer 100 having the semiconductor layer 13 formed on the single crystal AlN substrate 11 is preventable. Also in this respect, the lowered reliability of the device is preventable.

The above-described dimensions of the inclined surface RP of this embodiment is considered to be sufficiently large dimensions for preventing the acid solution from wrapping around. The above-described dimensions of the inclined surface RP of this embodiment is considered to be sufficiently large dimensions for releasing the strain of the single crystal AlN substrate 11, thus preventing the linear defect.

Accordingly, with this embodiment, an AlN single crystal substrate that can form a highly-reliable semiconductor device with high yield, a semiconductor wafer using the AlN single crystal substrate, and a manufacturing methods of the same can be provided.

### Embodiment 2

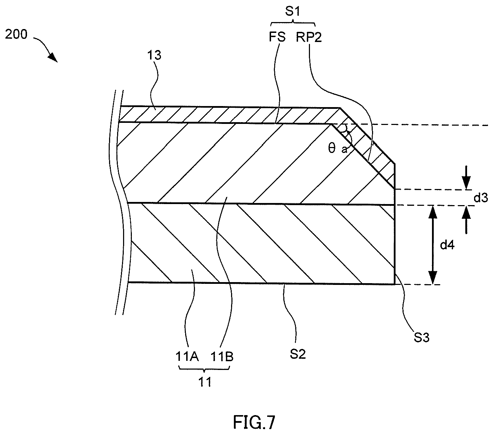

With reference to FIG. 7, a configuration of a semiconductor wafer 200 according to Embodiment 2 will be described. The semiconductor wafer 200 is different from the semiconductor wafer 100 of Embodiment 1 in that it has an inclined surface RP2 instead of the inclined surface RP, but other than that, it is configured similarly to the semiconductor wafer 100.

The inclined surface RP2 is formed on the first surface S1 of the single crystal AlN substrate 11 so as to incline from the outer edge of the flat surface FS to the end portion of the single crystal AlN substrate 11.

The inclined surface RP2 is formed so that a layer thickness d3 of the HVPE-AlN layer 11B is 1/5 (one fifth) or less of a layer thickness d4 of the PVT-AlN layer 11A on the side surface S3, that is, the end portion of the single crystal AlN substrate 11.

In this embodiment, the layer thickness of the PVT-AlN layer 11A may be, for example, 0.25 mm, may be 0.1 mm to 0.37 mm, or may be 0.23 mm on average. The layer thickness of the HVPE-AlN layer 11B may be, for example, 0.25 mm, may be 0.15 to 0.43 mm, or may be, for example, 0.27 mm on average.

Also in the semiconductor wafer 200 of this embodiment, no traces of the acid solution AC wrapping around up to the second surface S2, that is, the back surface were observed similarly to the case of Embodiment 1.

In the semiconductor wafer 200, the linear defect as described in Embodiment 1 was not observed.

As described above, the two-layer structure having the single crystal AlN layer (hereinafter also referred to as the HVPE-AlN) formed by the HVPE method on the single crystal AlN layer (hereinafter also referred to as the PVT-AlN layer) formed by the PVT method is likely to have the strain remaining in the HVPE-AlN layer. More specifically, growing the AlN thick film by the HVPE method on the PVT-AlN layer generates warpage of a crystal lattice surface with the C-plane that is convex downward, which applies a tensile strain in the HVPE-AlN layer. A slip defect is considered to occur to eliminate the strain in the HVPE-AlN layer in the process of temperature rise and decrease during the growth if the semiconductor layer 13 is grown by the MOCVD method on the HVPE-AlN layer thus having the remaining strain. It is also considered that, in the proximity of the outer periphery portion of the substrate of the comparative example, the larger the layer thickness of the HVPE-AlN layer is, the more difficult it is to eliminate the strain, and thus, the slip defect is likely to occur.

In this embodiment, reducing the layer thickness of the HVPE-AlN layer 11B on the side surface S3 down to 1/5 or less of the layer thickness of the PVT-AlN layer 11A is considered to be able to remove the portion where the strain is particularly likely to remain and reduce the occurrence of the linear defect.

Note that, regardless of the above-described condition of making the layer thickness of the HVPE-AlN layer 11B on the side surface S3 1/5 or less of the layer thickness of the PVT-AlN layer 11A, the layer thickness of the HVPE-AlN layer 11B on the side surface S3 is preferably 100 µm or less, and more preferably 50 µm or less from the aspect of sufficiently reducing the remaining strain in order to reduce the slip defect.

The inclined surface RP2 is preferred to incline at an angle of 23° or more and 29° or less with respect to the flat surface FS. In other words, the angle between the inclined surface RP2 and the flat surface FS is 23° or more and 29° or less (in FIG. 7, 23° ≤ θa ≤ 29°). For example, when the inclined surface RP2 has a width of 0.5 mm to 0.6 mm, and a height of 0.25 mm, 23° ≤ θa ≤ 29° is obtained.

The inclined surface RP2 is preferably formed to have the distance d1 from the end portion of the single crystal AlN substrate 11 of 0.45 mm or more and 0.75 mm (0.45 ≤ d1 ≤ 0.75), and the distance d2 from the flat surface FS in the direction perpendicular to the flat surface FS of 0.2 mm or more and 0.3 mm or less (0.2 ≤ d2 ≤ 0.3).

Thus, forming the inclined surface RP2 to incline by 23° or more and 29° or less with respect to the flat surface FS or to be 0.45 ≤ d1 ≤ 0.75 and 0.2 ≤ d2 ≤ 0.3 allows ensuring the width and the height of the inclined surface RP2. Thus, the inclined surface RP2 is considered to be able to prevent the acid solution from climbing up the side surface S3 and wrapping around up to the second surface S2 when only the flat surface FS of the single crystal AlN substrate 11 is immersed in the acid solution as the pretreatment when the semiconductor layer 13 of the semiconductor wafer 200 is grown. Thus, the lowered reliability of the device caused by temperature variation or the like during the growth of the semiconductor layer 13 is preventable.

Specifically, a third embodiment sample having a layer thickness d4 of the PVT-AlN layer 11A = 0.33 mm, a layer thickness of the HVPE-AlN layer 11B of 0.22 mm, d1 = 0.47 mm, d2 = 0.20 mm, d3 = 0.02 mm (6% of the layer thickness of the PVT-AlN layer 11A) was made, and it was confirmed that unevenness was not formed on the second surface S2, and thus, the acid solution wrapping around up to the second surface S2 was able to be inhibited. The occurrence of linear defect in the semiconductor layer 13 was also not observed.

On the other hand, a third comparative example sample having the layer thickness d4 of the PVT-AlN layer 11A = 0.25 mm, the layer thickness of the HVPE-AlN layer 11B of 0.23 mm, d1 = 0.28 mm, d2 = 0.17 mm, d3 = 0.06 mm (24% of the layer thickness of the PVT-AlN layer 11A) was made, and it was confirmed that pyramid-shaped unevenness was formed on an edge portion of the second surface, and thus, the acid solution wrapping around up to the second surface S2 occurred. The linear defect in the semiconductor layer 13 also occurred.

As described above, with this embodiment, the occurrence of the linear defect in the semiconductor wafer 200 having the inclined surface RP2 is preventable. Accordingly, the lowered reliability of the device is preventable.

Accordingly, with Embodiment 2, a single crystal AlN substrate that can manufacture a highly-reliable semiconductor device with high yield, a semiconductor wafer using the single crystal AlN substrate, and manufacturing methods of the same can be provided.

### [Modification]

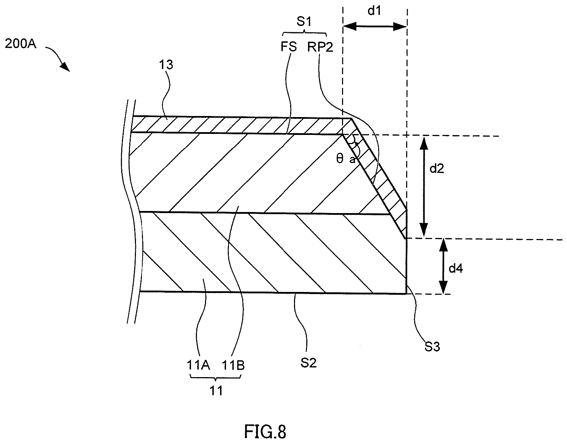

With reference to FIG. 8, a configuration of a semiconductor wafer 200A according to a modification of Embodiment 2 will be described. FIG. 8 is a cross-sectional view illustrating a structure of an end portion of the semiconductor wafer 200A according to the modification.

The semiconductor wafer 200A has the inclined surface RP2 formed to have the layer thickness d3 of the HVPE-AlN layer 11B of zero on the side surface S3 of the single crystal AlN substrate 11. In other words, the semiconductor wafer 200A has the HVPE-AlN layer 11B completely removed on the side surface S3 of the single crystal AlN substrate 11, and the ground surface reaches the PVT-AlN layer 11A. Other than that, the semiconductor wafer 200A is configured similarly to the semiconductor wafer 200.

As described above, the strain is likely to be generated in the outer periphery portion during the growth of the HVPE-AlN layer 11B. With this embodiment, it is considered that the portion highly possible to have the strain particularly remaining in the HVPE-AlN layer 11B is removable with more certainty, and the occurrence of the linear defect in the semiconductor wafer 200A can be reduced.

Furthermore, the inclined surface RP2 is preferred to incline at an angle of 23° or more and 29° or less with respect to the flat surface FS as well in this modification. In other words, the angle between the inclined surface RP2 and the flat surface FS is 23° or more and 29° or less (in FIG. 7, 23° ≤ θa ≤ 29°).

Also in this modification, the inclined surface RP2 is preferred to be formed to have the distance d1 from the end portion of the single crystal AlN substrate 11 of 0.45 mm or more and 0.75 mm or less (0.45 ≤ d1 ≤ 0.75), and the distance d2 from the flat surface FS in the direction perpendicular to the flat surface FS of 0.2 mm or more and 0.3 mm or less (0.2 ≤ d2 ≤ 0.3).

Thus, the inclined surface RP2 can prevent the acid solution from wrapping around up to the second surface S2 during the pretreatment when the semiconductor layer 13 is grown, and the lowered reliability of the device caused by temperature variation or the like during the growth of the semiconductor layer 13 can be prevented also in the semiconductor wafer 200A.

Specifically, a fourth embodimnt sample having a center portion layer thickness of the PVT-AlN layer 11A of 0.26 mm, an end portion layer thickness d4 = 0.20 mm, the layer thickness of the HVPE-AlN layer 11B of 0.25 mm, d1 = 0.69 mm, d2 = 0.31 mm, and d3 = 0 mm was made, and the acid solution wrapping around up to the second surface S2 was able to be inhibited, and the occurrence of the linear defect in the semiconductor layer 13 was also able to be inhibited.

### Embodiment 3

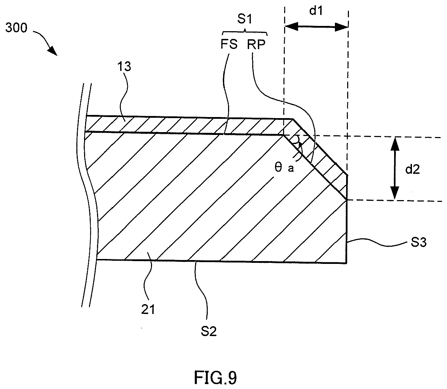

With reference to FIG. 9, a configuration of a semiconductor wafer 300 according to Embodiment 3 will be described. FIG. 9 is a cross-sectional view illustrating a structure of an end portion of the semiconductor wafer 300 according to Embodiment 3.

The semiconductor wafer 300 is configured similarly to the semiconductor wafer 100 of Embodiment 1 in that it has a single crystal AlN substrate 21 having a single layer structure instead of the single crystal AlN substrate 11 having the multiple layer structure.

The single crystal AlN substrate 21 is, for example, the single crystal AlN substrate having a single layer formed by the PVT method. The single crystal AlN substrate 21 is configured similarly to the single crystal AlN substrate 21 of Embodiment 1 except that it is a single layer structure.

Accordingly, the single crystal AlN substrate 21 has the first surface S1 as the upper surface, the second surface S2 as the lower surface, and the side surface S3. The first surface S1 has the flat surface FS and the inclined surface RP. The flat surface FS is the Al-polar surface, and the second surface S2 is the N-polar surface.

The inclined surface RP is formed to incline downward as approaching from the outer edge of the flat surface FS to the end portion of the single crystal AlN substrate 11, that is, the side surface S3, in other words, in the direction approaching to the second surface S2.

In this embodiment, the inclined surface RP is formed in dimensions similar to those of Embodiment 1. Specifically, the inclined surface RP is formed up to a position at 0.45 mm or more and 0.75 mm or less from the end portion of the single crystal AlN substrate 11. In other words, the width d1 of the inclined surface RP in top view, that is, the distance d1 from the end portion of the single crystal AlN substrate 11 illustrated in FIG. 9 is 0.45 mm or more and 0.75 mm or less (0.45 ≤ d1 ≤0.75).

The inclined surface RP is formed up to a position at 0.2 mm or more and 0.3 mm or less from the flat surface FS in the direction perpendicular to the flat surface FS. In other words, the height d2 of the inclined surface RP, that is, the distance d2 from the flat surface FS in the direction perpendicular to the flat surface FS illustrated in FIG. 9 is 0.2 mm or more and 0.3 mm or less (0.2 ≤ d2 ≤ 0.3).

The inclined surface RP having the above-described dimensions d1, d2 inclines at an angle of 23° or more and 29° or less with respect to the flat surface FS. In other words, the angle between the inclined surface RP and the flat surface FS is 23° or more and 29° or less (in FIG. 9, 23° ≤ θa ≤ 29°).

The semiconductor wafer 300 of this embodiment having such a configuration allows the inclined surface RP to prevent the acid solution from wrapping around up to the side surface S3 and the second surface S2 when only the flat surface FS is immersed in the acid solution as the pretreatment when the semiconductor layer 13 is formed. Accordingly, the lowered reliability of the device caused by temperature variation or the like during the growth of the semiconductor layer 13 with a part of the second surface S2 being etched is preventable.

With this embodiment, the occurrence of the linear defect in the semiconductor wafer 300 in which the semiconductor layer 13 has been formed on the single crystal AlN substrate 21 is preventable. The single crystal AlN substrate 21 is the single layer structure, and it has a strain generated during the manufacturing of the single crystal AlN substrate 21 remaining in the outer periphery portion in some cases, even though it is more remarkable in, for example, the two-layer structure formed of the PVT-AlN layer and the HVPE-AlN layer. Accordingly, disposing the inclined surface RP allows removing a portion that possibly have a strain. Also in this respect, the lowered reliability of the device is preventable.

Accordingly, with this embodiment, an AlN single crystal substrate that can form a highly-reliable semiconductor device with high yield, a semiconductor wafer using the AlN single crystal substrate, and manufacturing methods of the same can be provided.

The configurations in the above-described embodiments and manufacturing methods are merely examples, and are appropriately changeable according to the application and the like.

For example, while there has been described the case where the semiconductor wafer using the single crystal AlN substrate according to the above-described embodiments is applicable as an ultraviolet semiconductor light emitting element in manufacturing an ultraviolet light emitting diode (ultraviolet LED), the application is not limited thereto. The semiconductor wafer according to the above-described embodiments may be configured as a semiconductor wafer for an ultraviolet semiconductor laser element (ultraviolet LD: Laser Diode). The single crystal AlN substrate and the semiconductor wafer according to the above-described embodiments are applicable to an electronic device, such as a schottky barrier diode and a HEMT, other than the light emitting element.

In the above-described embodiments, a diameter of the single crystal AlN substrate can be approximately 45 mm to 100 mm for an example, but it is not limited to this. For example, it may be a diameter greater than 100 mm, and a thickness is allowed to be determined to be suitable for the diameter.

Note that, while in the above-described examples, the metal organic chemical vapor phase deposition method (MOCVD method) may be used when the single crystal AlN substrate is produced, it is more realistic to use the PVT method or the HVPE method from the aspect of the growth speed.

### DESCRIPTION OF REFERENCE SIGNS

11, 21 Single crystal AlN substrate
13 Semiconductor layer
S1 First surface
S2 Second surface
S3 Side surface
FS Flat surface
RP, RP2 Inclined surface
100, 200, 300 Semiconductor wafer

## Claims

1. A single crystal AlN substrate comprising:
a first surface having a flat surface as an Al-polar surface and an inclined surface formed from an outer edge of the flat surface to a side surface; and
a second surface as an opposite side surface of the first surface, the second surface being an N-polar surface, wherein
the inclined surface is formed up to a position having a distance from an end portion of the single crystal AlN substrate in a direction along the flat surface of 0.45 mm or more and 0.75 mm or less, and is formed up to a position having a distance from the flat surface in a direction perpendicular to the flat surface of 0.2 mm or more and 0.3 mm or less.

2. The single crystal AlN substrate according to claim 1, wherein
a carbon concentration is 5×10¹⁷ cm⁻³ or less.

3. A semiconductor wafer comprising
a laminated film having an AlN layer and an AlₓGaₗ₋ₓN (0.5 ≤ X ≤ 1) layer laminated in this order on the single crystal AlN substrate according to claim 1 or 2.

4. The semiconductor wafer according to claim 3, wherein
the AlₓGaₗ₋ₓN (0.5 ≤ X ≤ 1) layer is a composition gradient layer having a value of an Al composition X decreasing in a direction away from the single crystal AlN substrate.

5. A single crystal AlN substrate comprising:
a first surface having a flat surface as an Al-polar surface and an inclined surface formed from an outer edge of the flat surface to a side surface;
a second surface as an opposite side surface of the first surface, the second surface being an N-polar surface;
a PVT-AlN layer formed by a PVT method, the PVT-AlN layer having a lower surface as the second surface; and
a HVPE-AlN layer formed on an upper surface of the PVT-AlN layer by a HVPE method, the HVPE-AlN layer having an upper surface as the first surface, wherein
the HVPE-AlN layer has a layer thickness of 1/5 or less of a layer thickness of the PVT-AlN layer in an end surface of the single crystal AlN substrate.

6. The single crystal AlN substrate according to claim 5, wherein
an angle between the inclined surface and the flat surface is 23° or more and 29° or less.

7. The single crystal AlN substrate according to claim 5 or 6, wherein
the inclined surface is formed up to a position having a distance from an end portion of the single crystal AlN substrate in a direction along the flat surface of 0.45 mm or more and 0.75 mm or less, and is formed up to a position having a distance from the flat surface in a direction perpendicular to the flat surface of 0.2 mm or more and 0.3 mm or less.

8. The single crystal AlN substrate according to any one of claims 5 to 7, wherein
the HVPE-AlN layer has a layer thickness in the end portion of the single crystal AlN substrate of 100 µm or less.

9. The single crystal AlN substrate according to any one of claims 5 to 8, wherein
the HVPE-AlN layer has a layer thickness in the end portion of the single crystal AlN substrate of 50 µm or less.

10. A semiconductor wafer comprising
a laminated film including an AlN layer and an AlₓGaₗ₋ₓN (0.5 ≤ X ≤ 1) layer laminated in this order on the single crystal AlN substrate according to any one of claims 5 to 9.

11. The semiconductor wafer according to claim 10, wherein
the AlₓGaₗ₋ₓN (0.5 ≤ X ≤ 1) layer is a composition gradient layer having a value of an Al composition X decreasing in a direction away from the single crystal AlN substrate.

12. A method for manufacturing a single crystal AlN substrate, comprising:
a step (A) of forming a template substrate having an upper surface as an Al-polar surface by growing a HVPE-AlN layer by a HVPE method on a PVT-AlN layer formed by a PVT method; and
a chamfering step (B) of forming an inclined surface that inclines from an outer edge of a flat surface that is the Al-polar surface to a side surface of the single crystal AlN substrate by performing a chamfering process on a peripheral edge portion of an upper surface of the HVPE-AlN layer, wherein
after the chamfering step (B), the HVPE-AlN layer has a layer thickness of 1/5 or less of a layer thickness of the PVT-AlN layer in the side surface of the single crystal AlN substrate.

13. A method for manufacturing a semiconductor wafer having a semiconductor layer formed on a single crystal AlN substrate, comprising:
a step (A) of forming a template substrate having an upper surface as an Al-polar surface by growing a HVPE-AlN layer by a HVPE method on a PVT-AlN layer formed by a PVT method;
a chamfering step (B) of forming an inclined surface that inclines from an outer edge of a flat surface that is the Al-polar surface to a side surface of the single crystal AlN substrate by performing a chamfering process on a peripheral edge portion of an upper surface of the HVPE-AlN layer;
an immersing treatment step (C) of immersing the upper surface of the HVPE-AlN layer in an acid solution after the chamfering step (B); and
a step (D) of forming a laminated film having an AlN layer and an AlₓGaₗ₋ₓN (0.5 ≤ X ≤ 1) layer laminated in this order on the HVPE-AlN layer by a MOCVD method after the immersing treatment step (C), wherein
after the chamfering step (B), the HVPE-AlN layer has a layer thickness of 1/5 or less of a layer thickness of the PVT-AlN layer in the side surface of the single crystal AlN substrate.

14. The method for manufacturing the semiconductor wafer according to claim 13, wherein
in the immersing treatment step (C), the PVT-AlN layer has a lower surface exposed from the acid solution.
